# EUROPEAN PATENT APPLICATION

(11) **EP 2 151 856 A1**
(43) Date of publication of application: **10.02.2010**
(21) Application number: 08290757.7
(22) Date of filing: 06.08.2008
(51) Int. Cl.: H01L 21/324, H01L 21/20, H01L 33/00

(54) **Relaxation of strained layers**

(71) Applicant: S.O.I. TEC Silicon, 38190 Bernin (FR)
(72) Inventor: Letertre, Fabrice, 38240 Meylan (FR); Mazure, Carlos, 38190 Bernin (FR)
(74) Representative: Grünecker, Kinkeldey, Stockmair & Schwanhäusser Anwaltssozietät

(57) **Abstract**

The present invention relates to a method for relaxing a strained material layer, comprising depositing a first low-viscosity layer comprising a first compliant material on the strained material layer, depositing a second low-viscosity layer comprising a second compliant material on the strained material layer to form a first sandwiched structure and subjecting the first sandwiched structure to a heat treatment such that reflow of the first and the second low-viscosity layers is caused thereby at least partly relaxing the strained material layer.

## Description

### Field of Invention

The present invention relates to the field of strained layers and compliant substrates for application in the manufacture of semiconductor devices useful in electronic, opto-electronic, photovoltaic field and, in particular, to the relaxation of strained heteroepitaxial films by compliant substrates.

### Background of the Invention

The growth of thin films on substrates by heteroepitaxy is an important manufacturing step in the semiconductor technology. For instance, when native bulk substrates are not available or are too expensive, useful materials are often formed by heteroepitaxy on seed substrates. In the field of light-emitting semiconductor devices or solar cells there is a need to grow heteroepitaxial films of III/N materials on substrates as sapphire or SiC. However, when materials are formed by heteroepitaxy on substrates with a different lattice constants and different coefficients of thermal expansion as compared to the ones of the materials detrimental effects on material quality are caused by misfit compressive strain and the corresponding generation of dislocations and cracks. Thus, film of materials are formed by heteroepitaxy with a limited thickness such that neither crack nor dislocation occurred in the material. After transfer of the heteroepitaxial films to another substrate these films can, for instance, be used for epitaxial growth of layers used in electronic and opto-electronic; photovoltaic applications. However, thin heteroepitaxial films are strained due to the misfit of lattice parameter and the quality of epitaxial growth or subsequent steps can be deteriorated.

However, presently used methods for the relaxation of strained heteroepitaxial films often not show satisfying results with respect to the suppression of buckling, the formation of cracks, etc. and complete lateral relaxation can hardly be achieved. Thus, it is a problem underlying the present invention to provide a method for the complete or almost complete relaxation of a strained layer formed above a substrate that avoids or at least alleviates the above-mentioned defects.

### Description of the Invention

The above-mentioned problem is solved by the method for relaxing a strained material layer according to claim 1. The method comprises the steps of
depositing a first low-viscosity layer comprising a first compliant material on one face of the strained material layer;
depositing a second low-viscosity layer comprising a second compliant material on another face of the strained material layer to form a first sandwiched structure; and
subjecting the first sandwiched structure to a heat treatment such that reflow of the first and the second low-viscosity layers is caused thereby at least partly relaxing the strained material layer.

The term "low-viscosity" is used to indicate compliance and deformation ability of the thus specified layer during the heat treatment (see also discussion below). In particular, the heat treatment at a temperature above the glass transition temperature results in some reflow (plastic deformation e.g. due to some glass transition) of the first and the second low-viscosity layers thereby elastically relaxing the strained material layer. The provision of low-viscosity layers on both sides of the strained material layer allows in a free displacement of this strained material layer and, in particular, complete relaxation, if it is desired, without the formation of defects. Complete relaxation can be achieved by an appropriate choice of the temperature and duration of the heat treatment process.

A first substrate may be bonded to one of the first and the second low-viscosity layers before the step of subjecting the sandwich to the heat treatment. This first substrate might be advantageously used for transfer from a seed substrate on that the strained material layer was heteroepitaxially grown beforehand. Furthermore, a second substrate may be bonded to the other one of the first and the second low-viscosity layers before the step of heat treatment thereby forming a second sandwiched structure comprising both substrates, both low-viscosity layers and the strained material layer.

The second sandwiched structure comprising the first and the second substrates that may be made, e.g., of sapphire or some Si compound provides the advantage that buckling of the strained material layer during the relaxation heat treatment can reliably be prevented. In fact, the first and the second substrates act as almost infinite rigid mechanical stiffeners during the heat treatment that suppresses or significantly reduces surface buckling and allows a mainly lateral relaxation of the strained material layer. The dilatation of the substrates during the heat treatment may also participate to the relaxation of the strained material.

Preferably, the first and the second substrates are made of the same material or at least of materials of similar coefficients of thermal expansion in order to avoid a risk that the second sandwiched structure could break during the heat treatment due to a significantly different expansion on both sides of the strained material layer. The materials and the thicknesses of the substrates may advantageously be chosen such that the effect of mismatch between coefficients of thermal expansion is low enough at the reflow temperature so that the second sandwiched structure is mechanically stable during the heating to limit the risk of disassembling, cracks or splits of the substrates. The coefficients of thermal expansion of substrates may differ by not more than 20 %, preferably by not more than 10 % and even more preferably by not more than 5 % at the reflow temperature. For example, the first and second substrates may be chosen from the couple of Si/SiC, GaAS/Ge, SiC/AIN or GaN/AIN.

According to an embodiment the herein disclosed method also comprises detaching at least one of the first and second substrates and the low-viscosity layer to which it is bonded after the step of subjecting the sandwich to the heat treatment in order to expose at least one surface of the strained material layer. This exposed surface can subsequently be used for the further processing. In particular, it can be used for epitaxy of a layer useful for the manufacture of an electronic or opto-electronic semiconductor device or solar cells.

Furthermore, the strained material layer may be patterned before the heat treatment thereby forming strained material islands separated by interspaces. The formation of islands of the strained material layer further facilitates the relaxation process.. The shapes of the strained material islands are arbitrary, in principle, and might be chosen to be circular, square or rectangular for ease of manufacture. Due to the provision of two low-viscosity layers covering the strained material islands at two major surfaces lateral dimensions of some tenth parts of a millimeter, e.g., about 0.5 mm, or even larger can be chosen for the islands without strongly affecting the relaxation effect as compared to the case of significantly smaller islands which are used in the art.

According to another example, the strained material layer is patterned before depositing the second low-viscosity layer or both the strained material layer and the second low-viscosity layer are patterned after depositing the second low-viscosity layer on the strained material layer. Thus, the formation of the strained material islands can be performed after transfer of the strained material layer to the first substrate and before the second low-viscosity layer is deposited on the strained material or trenches (interspaces) are formed through the second low-viscosity layer and the strained material layer in which case the bonding to the second substrate includes bonding of the islands structures and interspaces are maintained in the bonded structure. In each case, the first low-viscosity layer may also be partially or completely etch. These interspaces may be advantageous in achieving a completely relaxed strained material layer after the heat treatment.

The first and/or the second low-viscosity layers can be deposited in the form of buried oxide layers each being a compliant material layer. In addition, an Si02 layer or undoped silicon glass or a SiN layer may be deposited on the strained material layer in order to enhance the adherence of the low-viscosity layer to the strained material layer.

According to a particularly useful example the strained material layer comprises or consists of InGaN which is useful for the production of LEDs and solar cells, for instance. It should be noted, however, that InGaN represents only one example for the material of the strained material layer. In fact, the strained material layer may, for instance, comprise or consist of a III/N material, polar, semi-polar or non-polar, chosen from a binary, ternary quaternary alloy.

The first and/or the second low-viscosity layers may comprise or consist of borophosphosilicate glass (BPSG) or an Si02 - compound comprising boron or phosphorous to cause elastically relaxation of the strained material layer due to reflow when heated above the glass transition temperature. The heat treatment is advantageously performed at a temperature of at least 800 °C, in particular, at least 850 °C, in order to allow for complete relaxation of the strained material layer or the strained material islands with no substantially buckling, respectively. In the following the term "strained material" refers to the strained material layer or the islands formed from the strained material layer.

When the second sandwiched structure is subject to the heat treatment, annealing temperatures in the range of 850 °C to 950 °C, in particular, 900 °C to 950 °C, can be used for causing a high (fast) reflow of the compliant material, since the strained material is capped and shielded by the first and second substrates and, thus, damage of the strained material layer is prevented even at such high temperatures.

In order to achieve a sufficiently high reflow (plastic deformation) the first and/or second low-viscosity layer may preferably comprise some % of weight boron but less than 5 % of weight boron, in particular, less than 4 % of weight boron in order to guarantee sufficient reflow at high anneal temperatures from 850 °C up to 950 °C but a sufficient mechanical rigidity at lower temperatures (about 800 °C) involved in epitaxy on the relaxed strained material (see description below). In addition, phosphorous my be present at 1 to 3 % by weight, in particular, 2 to 3 % by weight.

In the above-described examples of the herein disclosed method for relaxing a strained material layer, the strained material layer, in particular, a strained InGaN layer, may be grown on a seed substrate, in particular, a massive or composite seed substrate with a GaN layer being deposited on a support substrate before the step of depositing the first low-viscosity layer that is the first compliant material on the strained material layer and the strained material layer can be detached from the seed substrate and bonded by the first low-viscosity layer to the first substrate before depositing the second low-viscosity layer that is the second compliant material on the strained material layer for bonding to the second substrate to form the second sandwiched structure. The detachment of strained layer from the seed substrate may be performed by the SMART CUT ® technology, etching, laser lift off technique or any other suitable method. Thus, a heteroepitaxially grown strained material layer that was transferred to the first substrate can efficiently be relaxed in accordance with the present invention.

In case of polar strained materials, such that III-N materials and for example a c-plane InGaN material, the present invention has the advantage to easily allow the choice of the face of the InGaN material to free by the detachment of the first or the second substrate. Thus, one can free the III-polarity face as the Ga face for InGaN material after relaxation step that is particularly suitable for subsequent epitaxy.

Furthermore, the first low-viscosity layer and/or the second low-viscosity layer may comprise an absorption layer suitable for absorbing electromagnetic radiation in order to facilitate detachment after the heat treatment by means of laser lift off as know in the art. The material of the absorbing electromagnetic radiation may be for example SiN or other nitride compounds.

In the case of the provision of the absorption layer(s) it may be preferred that the absorption layer of the first low-viscosity layer is arranged at the interface of the first low-viscosity layer and the first substrate and/or the absorption layer of the second low-viscosity layer is arranged at the interface of the second low-viscosity layer and the second substrate in order to avoid damage of the at least partly relaxed strained material layer.

The herein disclosed method for relaxing a strained material layer in a elastic relaxation mode with substantially no buckling can advantageously be used for the production of semiconductor device for electronic, photovoltaic or opto-electronic applications. It is, therefore, provided a method for the manufacture of a semiconductor device, comprising the formation of at least partially relaxed strained material according to one of the examples described above, and further comprising epitaxially or homoepitaxially growing a material layer on the formed at least partially relaxed strained material, in particular, at least partially relaxed strained material islands, after removal of at least the first substrate together with the first low-viscosity layer or the second substrate together with the second low-viscosity layer.

Additional features and advantages of the present invention will be described with reference to the drawings. In the description, reference is made to the accompanying figures that are meant to illustrate preferred embodiments of the invention. It is understood that such embodiments do not represent the full scope of the invention.
Figure 1 illustrates an example of the inventive method for relaxing a strained material layer comprising the steps of forming a sandwiched structure comprising a borophosphosilicate glass above and below the strained material layer of InGaN and bonded to respective substrates and subjecting the sandwiched structure to heat treatment.
Figure 2 illustrates another example of the inventive method for relaxing a strained material layer wherein the strained material layer is patterned thereby forming islands and trenches filled by a compliant material layer.
Figure 3 illustrates another example of the inventive method for relaxing a strained material layer wherein the strained material layer is patterned thereby forming islands and open interspaces.

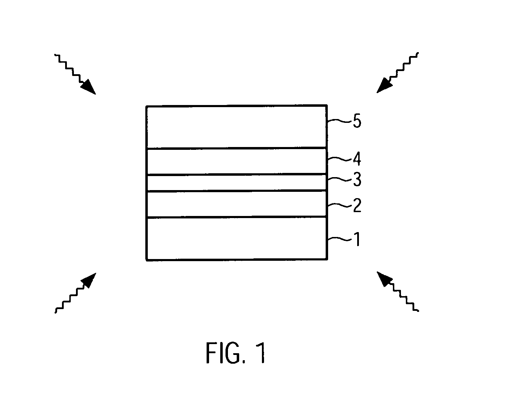

As shown in Figure 1 according to an example of the present invention a multilayer stack representing a sandwiched structure is formed and subject to heat treatment (indicated by the arrows). The sandwiched structure comprises a first substrate 1, a first borophosphosilicate glass layer 2, a strained material layer 3, a second borophosphosilicate glass layer 4 and a second substrate 5. Thus, in particular, the strained material layer 3 is sandwiched by two low-viscosity compliant borophosphosilicate glass layers 2 and 4.

The two low-viscosity compliant borophosphosilicate glass layers 2 and 4 allow for reliable complete elastical relaxation of the strained material layer 3 and the two substrates, which in the present example may be sapphire substrates, act as stiffeners to avoid any significant buckling of the strained material layer 3.

In the present example, the strained material layer 3 may be a c-plane InGaN film that was heteroepitaxially grown on a GaN seed layer deposited on some support substrate and transferred to the first substrate 1 by means of the first borophosphosilicate glass layer 2. The InGaN film may comprise 0.5 to 30 % of molar indium and the thickness of the InGaN film may be chosen from 10 to 300 nm. Preferably, the InGaN film comprises about 5 - 7 % of molar indium for a thickness of the film of about 100 nm.

In order to enhance the adherence between the strained material layer 3 and the first borophosphosilicate glass layer 2 an SiO₂ layer of a thickness of 10 - 100 nm may be deposited on the strained material layer 3, e.g., the InGaN film, before deposition of the first borophosphosilicate glass layer 2. After transfer to the first substrate 1 the second borophosphosilicate glass layer 4 is deposited on the free surface of the strained material layer 3, i.e. on the N face of the InGaN film. Again, an SiN film may be formed on the N face of the InGaN film before deposition of the second borophosphosilicate glass layer 4 in order to improve adherence. The second substrate was bonded to the second borophosphosilicate glass layer 4.

Both borophosphosilicate glass layers may be formed of the same material to avoid stresses or other asymmetric influences on the strained material layer 3 caused by different reflow properties during the heat treatment. The first and second borophosphosilicate glass layers 2 and 4 may comprise 4 - 5 % of weight of boron and can appropriately have thicknesses of 0.5 micrometer up to a few micrometers. The greater the thicknesses of the respective borophosphosilicate glass layers 2 and 4 are chosen, the faster the relaxation of the strained material layer 3 will be achieved.

The sandwiched structure shown in Figure 1 is annealed at a temperature of about 800 °C to 950 °C. Fast reflow of the compliant material is expected at such high temperatures that can be employed, since the InGaN film is protected by the first and second substrates 1 and 5.

Consider, for instance, a 1 % strained InGaN film (i.e. a lattice mismatch between the grown InGaN film and the GaN seed layer on which it was grown of about 1 %). For this case, a sample of 1 mm² has to laterally extend 10 micrometers in total in order to arrive at a completely relaxed state. This will be achieved by heat treatment of the sandwiched structure shown in Figure 1 at temperatures exceeding 850 °C without causing any significant buckling of the relaxed strained material layer 3.

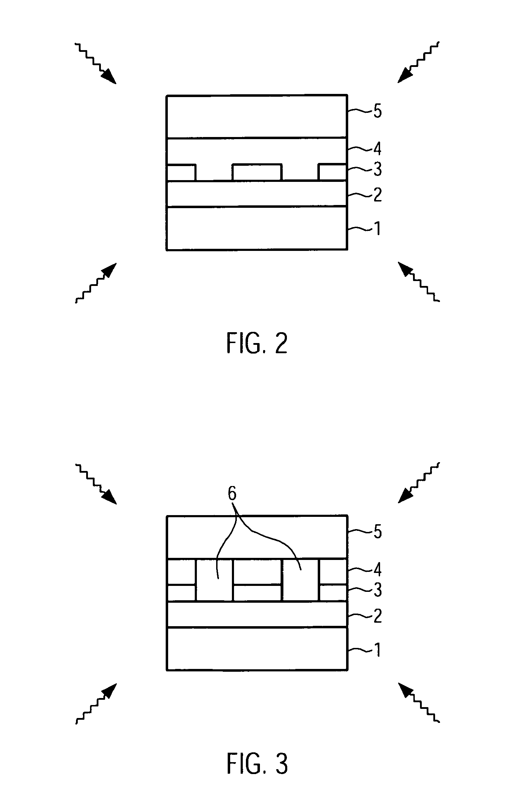

According to other examples, the strained material layer 3 is patterned by etching trenches (interspaces) in the layer thereby forming strained material islands. In the sandwiched structure shown in Figure 2 the continuous strained material layer 3 of Figure 1 was etched to form trenches before the deposition of the second borophosphosilicate glass layer 4. After the second borophosphosilicate glass layer 4 was deposited on the strained material it fills the trenches completely. Apart from the step of patterning of the strained material layer 3 the manufacture of the sandwiched structure is the same as the one described with reference to Figure 1.

Another example of a multilayer stack comprising a strained material layer that is to be relaxed by compliant material during heat treatment is shown in Figure 3. In this example, the second borophosphosilicate glass layer 4 was deposited on the continuous strained material layer 3 of Figure 1 and subsequently both the second borophosphosilicate glass layer 4 and the strained material layer 3 was patterned by etching trenches or interspaces 6. The borophosphosilicate glass layer 2 may also be partially or completely etched depending on the ability of the strained material to relax. Apart from this etching process, again, the manufacture of the sandwiched structure is the same as the one described with reference to Figure 1. Compared to the example shown in Figure 2 relaxation of the strained material islands 3 is not hindered by any material of the second borophosphosilicate glass layer 4 that was filled into the trenches.

After the relaxation of the strained material layer 3 of Figure 1 or the strained material islands shown in Figures 2 and 3, i.e. after termination of the heat treatment and cool down of the sandwiched structure, the first substrate 1 and the first borophosphosilicate glass layer 2 can be detached in order to get access to the Ga face of the relaxed strained InGaN film (islands) that can be used for (homo)epitaxially growth of an InGaN layer, for example.

Advantageously, the boron content of the second borophosphosilicate glass layer 2 is below some 4 to 5 % of weight such that a sufficiently high reflow (plastic deformation) can be achieved during the heat treatment at temperatures above 850 °C but concurrently a sufficient rigidity is provided at temperatures that are involved in the epitaxial growth, e.g., about 800 °C.

The epitaxy can be performed with relaxed InGaN material of (approximately) the same indium content as the relaxed strained material 3 of Figures 1 to 3. Depending on the quality of the crystallinity of the InGaN seed layer epitaxially grown layers on the relaxed strained material 3 with a dislocation density of about 5·105 to 5·109 cm2 with a thickness of 1 to 3 micrometers can be obtained.

According to an alternative embodiment different from the example shown in Figure 3, trenches in both layers 2 and 4 might be provided and even be preferred in view of the relaxation step. It also possible to partially etch the second borophosphosilicate glass layer 2.

All previously discussed embodiments are not intended as limitations but serve as examples illustrating features and advantages of the invention. It is to be understood that some or all of the above described features can also be combined in different ways.

## Claims

1. Method for relaxing a strained material layer, comprising depositing a first low-viscosity layer on one face of the strained material layer;
depositing a second low-viscosity layer on another face of the strained material layer to form a first sandwiched structure; and
subjecting the first sandwiched structure to a heat treatment such that reflow of the first and the second low-viscosity layers is caused thereby at least partly relaxing the strained material layer.

2. Method according to claim 1, further comprising bonding a first substrate to one of the first and the second low-viscosity layers before the step of subjecting the sandwich to the heat treatment.

3. Method according to claim 2, further comprising bonding a second substrate to the other of the first and the second low-viscosity layers before the step of heat treatment to form a second sandwiched structure.

4. Method according to claim 3, wherein the first and the second substrate are made of the same material or of materials exhibiting coefficients of thermal expansion that differ from each other by less than 20 %, in particular, less than 10 %.

5. Method according to claim 3 or 4, further comprising detaching at least one of the first and second substrates and the low-viscosity layer to which it is bonded after the step of subjecting the sandwich to the heat treatment in order to expose at least one surface of the at least partly relaxed strained material layer.

6. Method according to one of the preceding claims, further comprising patterning the strained material layer before the heat treatment thereby forming strained material islands, in particular, of lateral dimensions larger than 0.5 mm, separated by interspaces.

7. Method according to claim 6, wherein the strained material layer is patterned before depositing the second low-viscosity layer or both the strained material layer and the second low-viscosity layer are patterned after depositing the second low-viscosity layer on the strained material layer.

8. Method according to one of the preceding claims, wherein the strained material layer comprises or consists of III/N material, in particular, InGaN.

9. Method according to one of the preceding claims, wherein the first and/or the second low-viscosity layers comprise or consist of borophosphosilicate glass (BPSG) or an SiO₂ - compound comprising boron or phosphorous.

10. Method according to one of the preceding claims, wherein the heat treatment is performed at a temperature of at least 800 °C, in particular, at least 850 °C.

11. Method according to one of the preceding claims, wherein the first and/or second low-viscosity layer comprise less than 5 % of weight boron, in particular, less than 4 % of weight boron.

12. Method according to one of the claims 3 to 11, wherein the strained material layer, in particular a strained InGaN layer, is grown on a seed substrate, in particular, a GaN layer, deposited on a support substrate before the step of depositing the first low-viscosity layer on the strained material layer; and wherein
the strained material layer is detached from the seed substrate and bonded by the first low-viscosity layer to the first substrate before depositing the second low-viscosity layer on the strained material layer for bonding to the second substrate to form the second sandwiched structure.

13. Method according to one of the preceding claims wherein the first low-viscosity layer and/or the second low-viscosity layer comprise an absorption layer suitable for detachment of the first and/or the second substrate.

14. Method for the manufacture of a semiconductor device, comprising the formation of at least partially relaxed strained material according to one of the preceding claims, and further comprising epitaxially growing material layer(s) on the formed at least partially relaxed strained material, in particular, active layer(s) for application in LEDs, laser or photovoltaic field.

15. Method according to the precedent claims wherein the at least partially relaxed material is a polar III-N material and wherein the epitaxially grown layer is performed on the III-face polarity.

16. A second sandwiched structure after at least partial relaxation of strained material layer, in particular the at least partially relaxed strained layer is in InGaN and substrates are in sapphire.

17. A second sandwiched structure before and after at least partial relaxation of strained material islands in InGaN and trenches in both low viscosity layers, in particular, the relaxed strained layer is in InGaN and the both substrates are in sapphire or in silicon.
